Europäisches Patentamt

European Patent Office

Office européen des brevets

(19)

(11) **EP 0 697 151 B1**

(12) **EUROPEAN PATENT SPECIFICATION**

(45) Date of publication and mention
of the grant of the patent:
**16.06.1999 Bulletin 1999/24**

(21) Application number: **94913626.1**

(22) Date of filing: **29.04.1994**

(51) Int Cl.$^6$: **H03L 7/099**, H03L 7/18

(86) International application number:
**PCT/FI94/00167**

(87) International publication number:
**WO 94/26033 (10.11.1994 Gazette 1994/25)**

(54) **NUMERICALLY CONTROLLED OSCILLATOR AND DIGITAL PHASE LOCKED LOOP**

DIGITAL GESTEUERTER OSZILLATOR UND DIGITALE PLL-SCHALTUNG

OSCILLATOR A COMMANDE NUMERIQUE ET BOUCLE A PHASE BLOQUEE NUMERIQUE ASSERVIE

(84) Designated Contracting States:
**BE CH DE DK FR GB IT LI NL PT SE**

(30) Priority: **03.05.1993 FI 931991**

(43) Date of publication of application:
**21.02.1996 Bulletin 1996/08**

(73) Proprietor: **NOKIA TELECOMMUNICATIONS OY
02150 Espoo (FI)**

(72) Inventor: **PELTOLA, Seppo
FIN-90570 Oulu (FI)**

(74) Representative: **Tomlinson, Kerry John
Frank B. Dehn & Co.,
European Patent Attorneys,
179 Queen Victoria Street
London EC4V 4EL (GB)**

(56) References cited:
EP-A- 0 388 313          EP-A- 0 459 446
CA-A- 1 161 910

# Description

The invention relates to a numerically controlled oscillator according to the preamble of the attached claim 1, and to a digital phase-locked loop according to the preamble of the attached claim 4, comprising a numerically controlled oscillator.

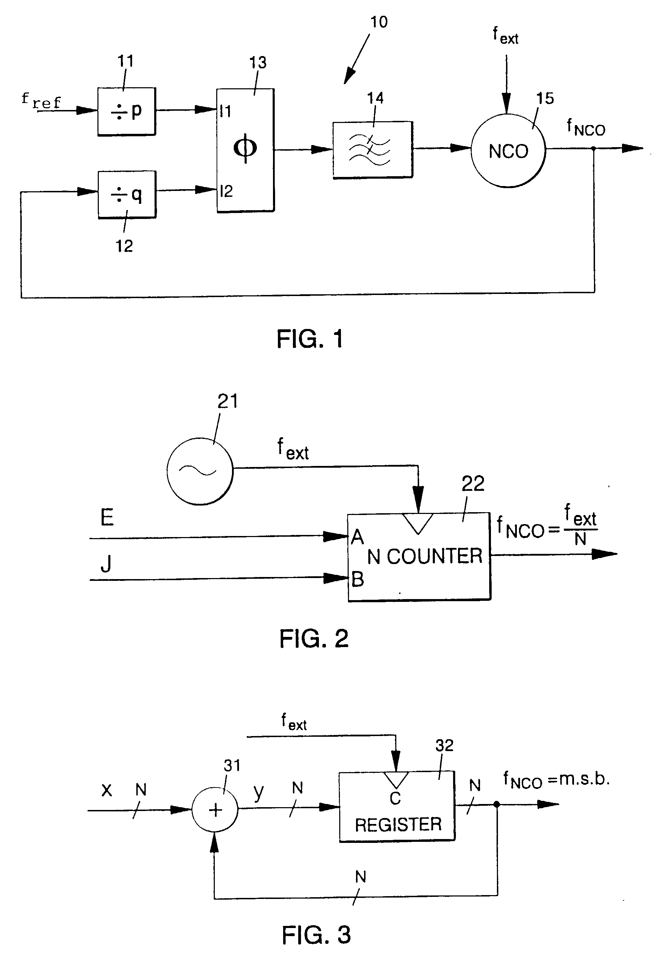

Figure 1 shows a digital phase-locked loop (DPLL) 10 known *per se* in its general form, in which it comprises a phase comparator 13, a lowpass-type loop filter 14 having an input to which the output signal of the phase comparator is connected, and a numerically controlled oscillator 15 arranged to be controlled by the loop filter. A signal is applied to each one of inputs I1 and I2 of the phase comparator through a frequency divider 11 and 12, respectively. A reference signal $f_{ref}$ is applied to the frequency divider 11, which divides the frequency of the reference signal by an integer p, whereby a signal having a frequency $f_{ref}/p$ (in this text the reference f refers both to the signal and to its frequency) is applied to the first input I1 in the phase comparator 13. The function of the numerically controlled oscillator 15 is to generate a wide range of frequencies from an external clock signal $f_{ext}$ having a frequency higher than that of the output signal $f_{NCO}$ of the oscillator. The output signal of the oscillator is applied through the frequency divider 12 back to the second input I2 of the phase comparator 13. The phase comparator thus compares the phase of a signal having the frequency $f_{ref}/p$ with the phase of a signal having the frequency $f_{NCO}/q$. The result of this comparison is lowpass-filtered in the loop filter 14, and the filtered signal is applied to the oscillator 15 to control it. When the loop is locked, Formula (1) is valid for the output signal of the loop:

$$(1) \qquad f_{NCO} = \frac{q}{p} f_{ref}$$

i.e. the frequency of the output signal is the frequency of the reference signal multiplied by the number q/p.

In prior art solutions, the numerically controlled oscillator 15 of the digital phase-locked loop is typically implemented in two different ways: either based on a counter or based on an accumulator.

Figure 2 illustrates an implementation of the numerically controlled oscillator 15 based on a counter. In this case, the implementation is based on a counter 22 which divides with a divisor N and the change of state of which is controlled by an accurate clock signal $f_{ext}$ fed from an external oscillator 21 and by a "lead" signal E and a "lag" signal J received as control data from the loop filter and connected to a counter input A and B, respectively, according to the concerned signal. The counter 22 is implemented by an N-state state machine having the above-mentioned signals E and J as its control signals. When the "lead" signal E is true, the state machine steps in place during one clock period, whereby the phase of the output signal $f_{NCO}$ is delayed by one clock period of the clock signal $f_{ext}$ of the external oscillator. When the "lag" signal J is true, the state machine skips one state, whereby the phase of the output signal $f_{NCO}$ is advanced by one clock period of the clock signal $f_{ext}$ of the external oscillator. Accordingly, the length of the phase correction step is always the period length of the output signal $f_{NCO}$ divided with the divisor N.

A drawback of the solution based on the N-counter is that the counter cannot be connected e.g. to a digital filter but it requires a filter of a certain type, such as a so-called lead-lag filter. The digital filter, however, would be a better alternative, as it provides a filter with a narrower bandwidth and, more generally, better properties than the simpler lead-lag filter, for instance.

Figure 3 illustrates an implementation of an accumulator-type numerically controlled oscillator. In this case the oscillator comprises an adder 31 and a register 32, to which the output of the adder is connected. The input signal of the accumulator-type oscillator is a binary (N-bit) digit x applied to a first input in the adder and indicating the magnitude and direction of the required phase correction. The binary digit is obtained from a digital loop filter, and it varies as a function of time in accordance with the filtering result. An output signal $f_{NCO}$ is generated by continuously adding binary digits x to the previous value of the register at the frequency of the external clock signal $f_{ext}$, which clock signal is connected to a clock input C in the register. At the rising edge of the external clock signal the N-bit value of the output signal y of the adder is stored in the register 32, the value of which indicates the current phase of the output signal. The output signal $f_{NCO}$ of the oscillator is formed by the most significant bit of the register.

The N-bit accumulator-type numerically controlled oscillator generates a frequency obtained from the frequency of the external oscillator in accordance with Formula (2)

$$(2) \qquad f_{NCO} = \frac{x}{2^N} \cdot f_{ext}$$

The word width N of the register of the accumulator-type numerically controlled oscillator affects both the gain factor of the oscillator and the highest frequency that can be generated. In order that a relatively low gain factor could be achieved, the word width has to be great; on the other hand, a great word width also increases the length of the adder and thus also the propagation delay of the adder. The accumulator-type numerically controlled oscillator can operate only if the length of the period of the external clock signal ($1/f_{ext}$) exceeds the delay of the adder. For this reason, it is impossible in many applications to achieve a gain factor low enough. The achievement of a low gain factor, however, is important in order that the phase-locked loop could have a narrow bandwidth.

According to a definition known *per se*, the gain factor $K_O$ of the accumulator-type numerically controlled oscillator is the ratio of a change in an angular frequency applied to the phase comparator to a change $\Delta x$ in a binary digit x controlling the oscillator:

$$(3) \qquad K_O = \frac{\dfrac{\Delta x}{2^N} \times \dfrac{2\pi f_{ext}}{q}}{\Delta x} = \frac{2\pi f_{ext}}{2^N q}$$

In the above Formula (3) a constant q is the divisor of the frequency divider (possibly) provided between the output of the oscillator and the second input of the phase comparator (cf. Figure 1).

Another drawback of the accumulator-type oscillator is that the gain factor cannot be set with any particularly high accuracy (it can be set by varying the word width N).

The digital phase-locked loop and the accumulator-type numerically controlled oscillator are described e.g. in *Digital Phase-Locked Loop with Jitter Bounded,* Walters, S. M., Troudet T., IEEE Transactions on Circuits and Systems, Vol. 36, No. 7, July 1989, which is referred to for a more detailed discussion.

Furthermore, EP 0 459 446 A1 discloses a digitally controlled oscillator, comprising a first accumulator- type oscillator section with a frequency word input, which is controlled by a second counter- type oscillator section having digital inputs to receive frequency setting values depending on the phase error derived from an external phase detector.

The object of the present invention is to avoid the above-described drawbacks and to provide a numerically controlled oscillator which has a gain factor which both can be made low and can be set more accurately than previously and which can also be connected to a digital filter. These objects are achieved by an oscillator according to the invention, which is characterized by what is disclosed in the characterizing portion of the attached claim 1. The phase-locked loop according to the invention, in turn, is characterized by what is disclosed in the characterizing portion of the attached claim 4.

The idea of the invention is to combine the previously known implementations of the numerically controlled oscillator in such a way that the frequency of the phase correction requests of an oscillator section based on a counter is controlled by an accumulator-type oscillator section.

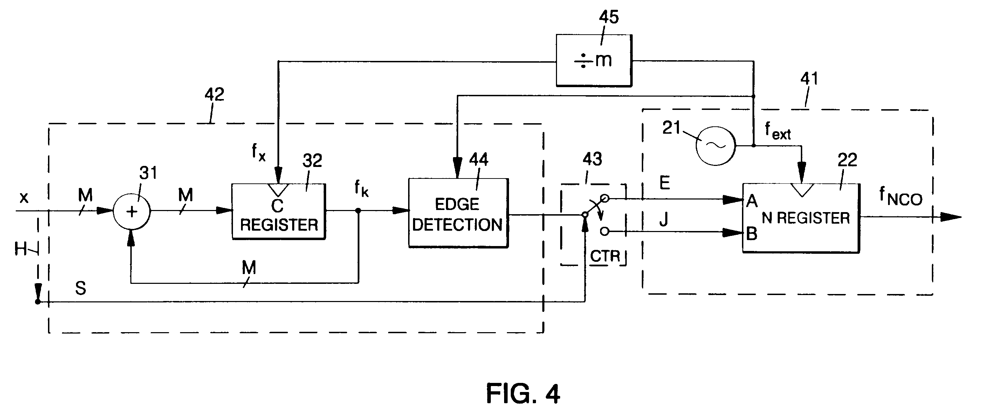

In the following the invention and its preferred embodiments will be described more fully with reference to Figure 4 in the examples shown in the attached drawings, where

Figure 1 is a block diagram illustrating a digital phase-locked loop known *per se*;
Figure 2 shows one previously known implementation of the numerically controlled oscillator of the digital phase-locked loop;
Figure 3 shows another previously known implementation of the numerically controlled oscillator of the digital phase-locked loop; and
Figure 4 shows an implementation according to the invention of the numerically controlled oscillator of the digital phase-locked loop.

Figure 4 is a block diagram illustrating a numerically controlled oscillator implemented according to the invention. The oscillator comprises a first numerically controlled oscillator section 41, which corresponds to the above-described counter-based oscillator implementation shown in Figure 2, where the change of state of a counter 22 is controlled by an accurate clock signal $f_{ext}$ from an external oscillator 21 and by a "lead" signal E and a "lag" signal J, respectively, received as control data. A second numerically controlled oscillator section 42 is connected to control the first oscillator section. The second oscillator section is based on the accumulator-type oscillator shown in Figure 3, comprising an adder 31 and a register 32, to which the output of the adder is connected and the output of which is fed back to one input in the adder. As the first oscillator section 41 corresponds to the counter-based oscillator, and the second oscillator section 42 corresponds substantially to the accumulator-type oscillator, the same reference numerals as in Figures 2 and 3 have been used in Figure 4 for corresponding parts.

The idea of the invention is to adjust the frequency of the phase correction requests (signals E and J) of the counter-based oscillator section 41 by the accumulator-type oscillator section 42, that is, in fact, by a binary digit x, as the accumulator-type oscillator is controlled by a binary digit, and additionally by a signal S indicating the direction of the phase correction. To effect the control, phase control inputs A and B in the first oscillator section are connected to respective outputs in a selector 43, and a selector input is connected to an output in the second oscillator section. The selector is controlled by the direction signal S, which is connected to a control input CTR in the selector. The direction signal S determines whether the output of the second oscillator section 42 is connected to the input A in the first oscillator section, corresponding to the "lead" signal, or to the input B in the first oscillator section, corresponding to the "lag" signal.

The second oscillator section 42 corresponds otherwise to the accumulator-type oscillator shown in Figure 3 except that the output signal of the register 32, now indicated with the reference $f_k$, is connected to an edge detector circuit 44, the output of which forms an output in the second oscillator section 42, which output is connected to an input in the selector 43. The edge detector circuit detects the rising edges of the output signal $f_k$ and shapes the signal such that its pulse width corresponds to the pulse width of the external clock signal $f_{ext}$ (which controls the N counter 22).

A signal obtained from the register 32 of the second oscillator section thus has a frequency which can be obtained as follows:

$$(4) \qquad f_k = \frac{x}{2^M} f_x$$

This frequency is also the frequency of pulses from the output of the edge detector circuit, that is, a signal having this frequency either advances or delays the phase of the counter 22 of the first oscillator section. The frequency of the numerically controlled oscillator according to the invention can now be calculated from Formula (5):

$$(5) \qquad f_{NCO} = \frac{f_{ext}}{N} \pm \frac{x\, f_x}{2^M\, N}$$

In Formula (5), the sign of the $\pm$ operation depends on the sign of the phase correction signal S. On the basis of Formula (5), it is possible to calculate the gain factor of the numerically controlled oscillator shown in Figure 4, which factor, according to a definition known *per se*, is the ratio of a change in an angular frequency applied to the phase comparator of the phase-locked loop to a change in the controlling binary digit x. The gain factor will thus be:

$$(6) \qquad K_O = \frac{\dfrac{2\pi\Delta f_{NCO}}{q}}{\Delta x} = \frac{2\pi\dfrac{\Delta x f_x}{2^M\, N}}{\Delta x\, q} = \frac{2\pi f_x}{2^M\, N\, q}$$

where a constant q is the divisor of a frequency divider (possibly) provided between the output of the oscillator and the input of the phase comparator in the feedback loop of the phase-locked signal.

It appears from Formula (6) that a low gain factor is easy to achieve in the oscillator according to the invention by setting the frequency of the signal $f_x$ to a low value, whereby the value of the gain factor also diminishes. The signal $f_x$ controlling storing into the register 32 is, in fact, advantageously obtained by dividing the frequency of the signal $f_{ext}$ from the external oscillator 21 of the first oscillator section 41 by a divisor m in a frequency divider 45. The frequency of the signal $f_x$ is thus considerably lower than that of the signal $f_{ext}$.

The numerically controlled oscillator shown in Figure 4 can be connected to a digital loop filter, as the desired control signals x and S are obtained directly from the digital filter, or the output signal of the digital filter is at least easy to shape so that the desired control signals are obtained. The direction signal S, for instance, may be contained in a binary word x obtained from the loop filter, and it can be extracted from the binary word into a separate control signal, which is connected, as described above, to control the selector 43. (In Figure 4, this alternative is shown by an arrow H drawn by a broken line).

Even though the invention has been described above with reference to the examples of the attached drawings, it is self-evident that the invention is not limited to the examples, but it may be modified within the inventive idea disclosed above and in the attached claims. For instance, the more detailed switching arrangements of the oscillator and the phase-locked loop may vary, even though the accumulator-type oscillator section is connected to control the counter-type oscillator section in accordance with the idea of the invention. Essential is that the accumulator-type oscillator section controls the counter-type oscillator section, whereas it is not essential in which way it is connected to control the counter-type oscillator section, i.e. whether it is connected to the counter-type oscillator section directly or through various intermediate circuits irrelevant to the idea of the invention. The solution according to the invention is not only applicable in all digital phase locks where the oscillator is controlled by a binary word but, in principle, it is also possible to use the invention in other applications where a similar control is available.

**Claims**

1. Numerically controlled oscillator comprising a first oscillator section (41) having a counter (22) acting as a frequency divider and an external oscillator (21) supplying a clock signal ($f_{ext}$) connected to the counter (22) for generating an output signal ($f_{NCO}$) with a divided frequency from said clock signal, the counter (22) comprising at least one phase control input (A, B) for connecting phase correction requests to the counter (22) for adjusting the phase of said output signal ($f_{NCO}$) in a desired direction, **characterized** in that a second accumulator-type oscillator section (42) is connected to control the phase of the output signal ($f_{NCO}$) of the first oscillator section (41), the second oscillator section comprising an adder (31) and a register (32), to which the output of the adder is connected, the adder (31) having a first input for connecting a binary digit (x) to control said second oscillator section (42), and a second input for feeding the output signal of the register back to the adder (31).

2. Oscillator according to claim 1, comprising two phase control inputs (A, B), **characterized** in that said accumulator-type oscillator section (42) is operationally connected to one of the phase control inputs through a selector (43), which comprises means for connecting a signal present at its input to a desired output.

3. Oscillator according to claim 1, **characterized** in that a clock input (C) in said register (32), to which a clock signal ($f_x$) is connectable to control storing into the register, is connected to said external oscillator (21) through a frequency divider (45) for dividing the frequency of the signal ($f_{ext}$) from the external oscillator (21) before connecting it to the clock input (C) in the register.

4. Phase-locked loop comprising

- a phase comparator (13) having at least two comparator inputs for comparing the phases of signals connected to the inputs;
- a lowpass-type loop filter (14) having an input to which the output of the phase comparator is connected; and
- a numerically controlled oscillator (15) arranged to be controlled by the loop filter (14) and comprising a first oscillator section (41) having a counter (22) acting as a frequency divider and an external oscillator (21) supplying a clock signal ($f_{ext}$) connected to the counter (22) for generating an output signal ($f_{NCO}$) with a divided frequency from said clock signal, the counter (22) comprising at least one phase control input (A, B) for connecting phase correction requests to the counter (22) for adjusting the phase of said output signal ($f_{NCO}$) in a desired direction, **characterized** in that a second accumulator-type oscillator section (42) is connected to control the phase of the output signal ($f_{NCO}$) of the first oscillator section (41), the second oscillator section comprising an adder (31) and a register (32), to which the output of the adder is connected, the adder (31) having a first input connected operationally to the loop filter (14) for connecting the loop filter to control said second oscillator section (42), and a second input for feeding the output signal of the register back to the adder (31).

5. Phase-locked loop according to claim 4, comprising two phase control inputs (A, B), **characterized** in that said accumulator-type oscillator section (42) is operationally connected to one of the phase control inputs through a selector (43), which comprises a control input ( CTR) operationally connected to the loop filter (14) for connecting the loop filter to control the switching of a signal present at the selector input to a desired selector output.

6. Phase-locked loop according to claim 4, **characterized** in that a clock input (C) in said register (32), to which a clock signal ($f_x$) is connectable to control storing into the register, is connected to said external oscillator (21) through a frequency divider (45) for dividing the frequency of the signal ($f_{ext}$) from the external oscillator (21) before connecting it to the clock input (C) in the register.

**Patentansprüche**

1. Numerisch gesteuerter Oszillator mit einem ersten Oszillatorteil **(41)** mit einem als Frequenzteiler dienenden Zähler **(22)** und einem mit dem Zähler **(22)** verbundenen, ein Taktsignal ($f_{ext}$) zuführenden externen Oszillator **(21)** zum Erzeugen eines Ausgangssignals ($f_{NCO}$) mit einer aus dem Taktsignal geteilten Frequenz, wobei der Zähler **(22)** zumindest einen Phasensteuereingang **(A, B)** zum Anschließen von Phasenkorrekturanforderungen an den Zähler **(22)** zum Einstellen der Phase des Ausgangssignals ($f_{NCO}$) in einer gewünschten Richtung, **dadurch gekennzeichnet, daß** ein zweiter Oszillatorteil **(42)** vorn Akkumulatortyp zum Steuern der Phase des Ausgangssignals ($f_{NCO}$) des ersten Oszillatorteils **(41)** angeschlossen ist, wobei der zweite Oszillatorteil einen Addierer **(31)** und ein mit dem Ausgang des Addierers verbundenes Register **(32)** aufweist, wobei der Addierer **(31)** einen ersten Eingang zum Verbinden einer Binärzahl **(x)** zum Steuern des zweiten Oszillatorteils **(42)** aufweist, und einen zweiten Eingang zum Zurücktühren des Ausgangssignals des Registers zu dem Addierer **(31).**

2. Oszillator nach Anspruch 1, mit zwei Phasensteuereingängen **(A, B)**, **dadurch gekennzeichnet, daß** der Oszilltorteil **(42)** vom Akkumulatortyp operativ mit einem der Phasensteuereingänge über einen Selektor **(43)** verbunden ist, der eine Einrichtung aufweist zum Verbinden eines an seinem Eingang anliegenden Signals mit einem gewünschten Ausgang.

3. Oszillator nach Anspruch 1, **dadurch gekennzeichnet, daß** ein Takteingang **(C)** des Registers **(32),** an den ein Taktsignal **($f_x$)** zum Steuern des Speicherns in das Register anschließbar ist, mit dem externen Oszillator **(21)** über einen Frequenzteiler **(45)** zum Teilen der Frequenz des Signals **($f_{ext}$)** des externen Oszillators **(21)** vor dessen Verbindung mit dem Takteingang **(C)** des Registers verbunden ist.

4. Phasenregelschleife mit

- einem Phasenkomparator **(13)** mit zumindest zwei Komparatoreingängen zum Vergleichen der Phasen von mit den Eingängen verbundenen Signalen;
- einem Tiefpaßschleifenfilter **(14)** mit einem Eingang, der mit dem Ausgang des Phasenkomparators verbunden ist; und
- einem numerisch gesteuerten Oszillator **(15),** der zum Steuern durch das Schleifenfilter **(14)** ausgestaltet ist und einen ersten Oszillatorteil

(41) mit einem als Frequenzteiler dienenden Zähler (22) aufweist und einen ein Taktsignal (f$_{ext}$) zuführenden externen Oszillator (21), der mit dem Zähler (22) verbunden ist, zum Erzeugen eines Ausgangssignals (f$_{NCO}$) mit einer aus dem Taktsignal geteilten Frequenz, wobei der Zähler (22) zumindest einen Phasensteuereingang (A, B) aufweist zum Anschließen von Phasenkorrekturanforderungen an den Zähler (22) zum Einstellen der Phase des Ausgangssignals (f$_{NCO}$) in einer gewünschten Richtung,

**dadurch gekennzeichnet, daß**

ein zweiter Oszillatorteil (42) vom Akkumulatortyp zum Steuern der Phase des Ausgangssignals (f$_{NCO}$) des ersten Oszillatorteils (41) angeschlossen ist, wobei der zweite Oszillatorteil einen Addierer (31) und ein mit dem Ausgang des Addierers verbundenes Register (32) aufweist, wobei der Addierer (31) einen mit dem Schleifenfilter (14) operativ verbundenen ersten Eingang aufweist zum Verbinden des Schleifenfilters zum Steuern des zweiten Oszillatorteils (42), und einen zweiten Eingang zum Zurückführen des Ausgangssignals des Registers zu dem Addierer (31).

5. Phasenregelschleife nach Anspruch 4, mit zwei Phasensteuereingängen (A, B),
**dadurch gekennzeichnet, daß**
der Oszillatorteil (42) vom Akkumulatortyp operativ mit den Phasensteuereingängen über einen Selektor (43) verbunden ist, der einen operativ mit dem Schleifenfilter (14) verbundenen Steuereingang (CTR) aufweist zum Anschließen des Schleifenfilters zum Steuern des Schaltens eines an dem Selektoreingang anliegenden Signals zu einem gewünschten Selektorausgang.

6. Phasenregelschleife nach Anspruch 4,
**dadurch gekennzeichnet, daß**
ein Takteingang (C) des Registers (32), an den ein Taktsignal (f$_x$) zum Steuern des Speicherns in das Register anschließbar ist, mit dem externen Oszillator (21) über einen Frequenzteiler (45) zum Teilen der Frequenz des Signals (f$_{ext}$) des externen Oszillators (21) vor dessen Verbindung mit dem Takteingang (C) des Registers anschließbar ist.

**Revendications**

1. Oscillateur à commande numérique comprenant une première section d'oscillateur (41) ayant un compteur (22) qui joue le rôle d'un diviseur de fréquence et un oscillateur externe (21) qui envoie un signal d'horloge (f$_{ext}$) et qui est raccordé au compteur (22) pour produire à partir dudit signal d'horloge un signal de sortie (f$_{NCO}$) ayant une fréquence divisée, le compteur (22) comprenant au moins une entrée à commande de phase (A, B) servant à la connexion de corrections de phase demandées au compteur (22) pour régler la phase dudit signal de sortie (f$_{NCO}$) dans une direction souhaitée, caractérisé en ce qu'une deuxième section d'oscillateur (42) du type accumulateur est connectée de façon à commander la phase du signal de sortie (f$_{NCO}$) de la première section d'oscillateur (41), la deuxième section d'oscillateur comprenant un additionneur (31) et un registre (32), auquel est raccordée la sortie de l'additionneur, l'additionneur (31) ayant une première entrée servant à la connexion d'un premier chiffre binaire (x) pour commander ladite deuxième section d'oscillateur (42), et une deuxième entrée servant au retour du signal de sortie du registre vers l'additionneur (31).

2. Oscillateur selon la revendication 1, comprenant deux entrées à commande de phase (A, B), caractérisé en ce que ladite section d'oscillateur (42) du type accumulateur est reliée fonctionnellement aux entrées à commande de phase par l'intermédiaire d'un sélecteur (43) qui comprend des moyens permettant la connexion d'un signal présent à son entrée à une sortie souhaitée.

3. Oscillateur selon la revendication 1, caractérisé en ce qu'une entrée d'horloge (C) dans ledit registre (32), à laquelle un signal d'horloge (f$_x$) peut être connecté pour commander la mémorisation dans le registre, est connectée audit oscillateur externe (21) par l'intermédiaire d'un diviseur de fréquence (45), qui sert à diviser la fréquence du signal (f$_{ext}$) provenant de l'oscillateur externe (21) avant de le connecter à ladite entrée d'horloge (C) du registre.

4. Boucle à phase asservie, comprenant :

- un comparateur de phase (13) ayant au moins deux entrées de comparateur pour comparer les phases des signaux connectés aux entrées ;
- filtre de boucle du type passe-bas (14) ayant une entrée à laquelle est connectée la sortic du comparateur de phase ; et
- un oscillateur à commande numérique (15) conçu pour être commandé par le filtre de boucle (14) et comprenant une première section d'oscillateur (41) ayant un compteur (22) jouant le rôle d'un diviseur de fréquence et un oscillateur externe (21) qui envoie un signal d'horloge (f$_{ext}$) et qui est raccordé au compteur (22) pour produire à partir dudit signal d'horloge un signal de sortie (f$_{NCO}$) ayant une fréquence divisée, le compteur (22) comprenant au moins une entrée à commande de phase (A, B) servant à la connexion de corrections de phase demandées au compteur (22) pour régler la phase dudit signal de sortie ($f_{NCO}$) dans une direction souhaitée, caractérisé en ce qu'une deuxième section d'oscillateur (42) du type accumulateur est connectée de façon à commander la phase du signal de sortie ($f_{NCO}$) de la première section d'oscillateur (41), la deuxième section d'oscillateur comprenant un additionneur (31) et un registre (32), auquel est raccordée la sortie de l'additionneur, l'additionneur (31) ayant une première entrée reliée fonctionnellement au filtre de boucle (14) pour connecter le filtre de boucle de telle sorte qu'il commande ladite deuxième section d'oscillateur (42), et une deuxième entrée servant au retour du signal de sortie du registre vers l'additionneur (31).

5. Boucle à phase asservie selon la revendication 4, comprenant deux entrées à commande de phase (A, B), caractérisé en ce que ladite section d'oscillateur (42) du type accumulateur est reliée fonctionnellement aux entrées à commande de phase par l'intermédiaire d'un sélecteur (43), qui comprend une entrée de commande (CTR) reliée fonctionnellement au filtre de boucle (14) pour connecter le filtre de boucle de telle sorte qu'il commande la commutation d'un signal présent au niveau de l'entrée du sélecteur à une sortie souhaitée du sélecteur.

6. Boucle à phase asservie selon la revendication 4, caractérisée en ce qu'une entrée d'horloge (C) dans ledit registre (32), à laquelle un signal d'horloge ($f_x$) peut être connecté pour commander la mémorisation dans le registre, est connectée audit oscillateur externe (21) par l'intermédiaire d'un diviseur de fréquence (45), qui sert à diviser la fréquence du signal ($f_{ext}$) provenant de l'oscillateur externe (21) avant de le connecter à ladite entrée d'horloge (C) du registre.

**FIG. 1**

$$f_{NCO} = \frac{f_{ext}}{N}$$

**FIG. 2**

$f_{NCO} = m.s.b.$

**FIG. 3**

FIG. 4